# EUROPEAN PATENT SPECIFICATION

(11) **EP 0 776 012 B1**
(45) Date of publication and mention of the grant of the patent: **08.10.2003**
(21) Application number: 96308036.1
(22) Date of filing: 06.11.1996
(51) Int. Cl.: G11C 16/06, G11C 16/04

(54) **Data read circuit of nonvolatile semiconductor memory device**
Datenleseschaltung einer nichtflüchtigen Halbleiterspeicheranordnung
Dispositif de lecture des données de dispositif de mémoire à semi-conducteurs non-volatile

(30) Priority: 15.11.1995 KR 4150695
(43) Date of publication of application: 28.05.1997
(73) Proprietor: Samsung Electronics Co., Ltd., Suwon City, Kyungki-do (KR)
(72) Inventor: Lee, Hyong-Gon, Suwon-city, Kyungki-do (KR)
(74) Representative: Tunstall, Christopher Stephen

(56) References cited:
- GB-A- 2 226 184
- US-A- 5 268 867
- US-A- 5 519 660
- US-A- 5 761 132

## Description

### Background to the Invention

The present invention relates to a nonvolatile semiconductor memory such as an EEPROM and more particularly to a data read circuit for such a memory device.

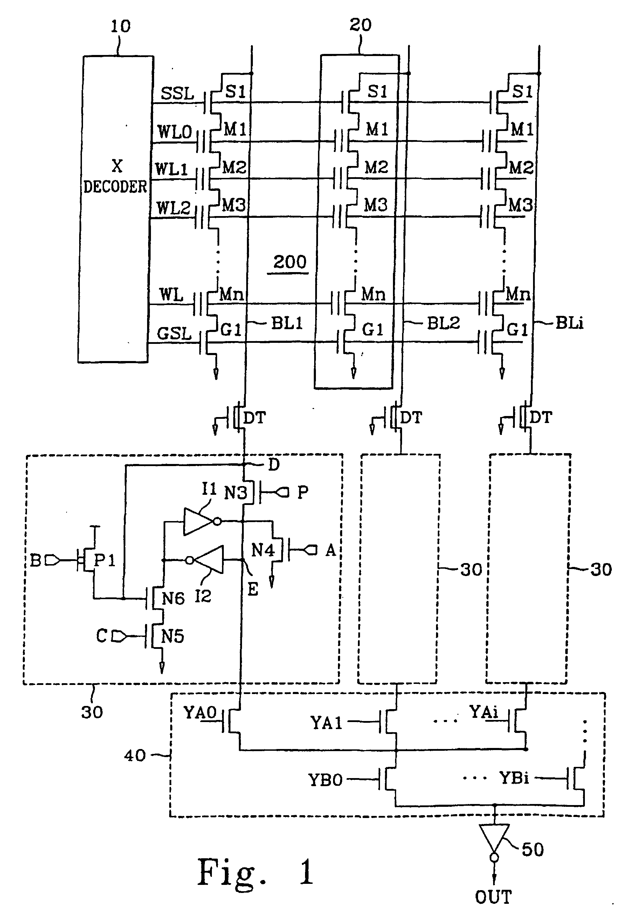

Generally, in a NAND structured nonvolatile memory including a cell array in which a plurality of memory cells are serially connected to one another to form a string, a page read operation is performed according to the following process. That is, data of all memory cells of a selected row are concurrently read and temporarily stored in a store in the memory. Then, the data are sequentially output according to an external serial output signal. This page read operation is accomplished by a page buffer consisting of a latch circuit. The page buffer is shown in Fig. 1 in relation to the memory cell array.

Fig. 1 is a block diagram showing one embodiment of a memory core scheme including a conventional page buffer. This shows a portion in relation to a read path of the page buffer for a NAND structured flash memory. As shown in Fig. 1, a plurality of memory transistors M1 to Mn form one NAND cell string 20. These memory transistors are arranged in the form of matrix with word lines in the roe direction and bit lines in the column direction, to form a memory cell array 200. String selection transistors S1 connected to bit lines BL1 to BLi and ground selection transistors G1 are connected to respective ends of the memory cells in one string 20. An X-decoder 10 which designates a row is connected to the control gates of the memory transistors through word lines WL0 to WLi.

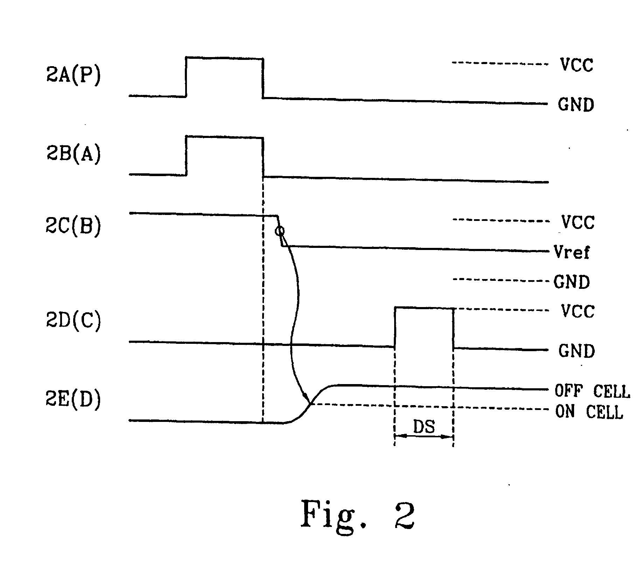

Page buffer 30, one of which is connected to each bit line through a dividing transistor DT consists of a PMOS transistor P1 for precharging the bit line and for supplying a load current required for sensing, NMOS transistors N6 and N5 for opening a data latch path, two latch inverters I1 and I2 for latching data and NMOS transistors N3 and N4 for resetting the latches by discharging the bit line. Page buffer 30 is connected to a plurality of column decoding transistor portions 40 which respond to a column decoding signal. Decoding transistor portions 40 are connected to an output buffer 50 connected to an input/output pad. The gates of the transistors in page buffer 30 receive various control signals. These control signals are shown as waveforms 2A to 2D in Fig. 2.

The read operation of the conventional page buffer will now be explained with reference to Figs. 1 and 2. First of all, X-decoder 10 selects a memory transistor from the string. Conventionally, ground voltage is supplied to the word line of the memory cell selected and a transit voltage such as power supply voltage is supplied to the unselected word lines. The selection of a string is performed by supplying a signal which turns on the string selection transistor. If the ground voltage is supplied to the word line when the memory cell selected is programmed as a depletion-mode transistor, the transistor is turned on and current flows through it. This case will be called an "on" cell, the opposite case being an "off" cell.

When the read operation of data stored in the memory cell starts, page buffer 30 performs the read operation by latching data through a node D on the bit line. That is, just before the read operation, page buffer 30 initializes the level of the bit line by discharging it to ground voltage using transistors N3 and N4 respectively receiving signals P and A shown in Figs. 2A and 2B. Thereafter, the page buffer maintains the level of the corresponding bit line at a predetermined voltage by precharging the bit line using transistor P1 receiving a signal B shown in Fig. 2C. Here, signal B is an output signal supplied from a current mirror circuit. Accordingly, a voltage level according to the programmed state of the memory cell appears on node D. If the memory cell selected is an "on" cell, the voltage level which appears on node D is lower than in case of an "off" cell.

Then, as transistor N5 receiving a signal C shown in Fig. 2D is turned on or turned off, a voltage level shown in Fig. 2E is developed on node D according to the programmed state of the memory cell. This is sensed by two latch inverters I1 and I2 within a section DS. That is, when the sensing node D is in a "high" level ("off" cell) according to the programmed state of the memory cell selected, the latch inverters are inverted from a logic state initialized according to the state of NMOS transistors N6 and N5. On the other hand, when the sensing node D is in the ground level ("on" cell), the inverter latches maintain their logic state as initialized according to the state of NMOS transistor N4 and NMOS transistor N3.

If the data from the memory cells read as above are all stored in page buffer 30, latch signal C is changed from "high" to "low", transistor N5 is turned off and column address decoding signals YA0-i and YBO-i are sequentially toggled. By doing so, data stored in the latch is externally output through output buffer 50.

However, this conventional prior art data read circuit has a page buffer circuit of complicated configuration, having latches connected to every bit line. This results in an increase of memory chip size. Furthermore, as the size of a memory cell array is reduced, the internal circuitry of the page buffer must be decreased. Accordingly, design options for the memory cell array are limited.

An object of the present invention is to provide a data read circuit of a nonvolatile semiconductor memory which can solve the aforementioned problems of the conventional memory.

Another object of the present invention is to provide a data read circuit of a nonvolatile semiconductor memory, which reads data from a memory cell without employing a latch circuit for latching data.

A further object of the present invention is to provide a semiconductor memory in which the data read circuit connected to the memory cell array is simplified to reduce chip size.

A still further object of the present invention is to provide a data read circuit which stably performs a read operation without employing a page buffer.

### Summary of the Invention

To accomplish the objects of the present invention, there is provided a nonvolatile semiconductor memory device comprising:
a memory cell array having a plurality of NAND cell strings, each including a plurality of memory transistors?
a plurality of bit lines, one for each NAND cell string;
a read unit for each bit line comprising:
   a switch unit for connecting the NAND cell string to a first portion of the bit line in response to a selection signal;
   a precharge unit for precharging a second portion of the bit line in response to a precharge signal;
   means for discharging the precharge on the second portion of the bit line to the first portion of the bit line if the voltage level on the first portion of the bit line is below a given level; and
   a column selecting unit for connecting the second portion of the bit line to a common sensing node in response to a respective column decoding signal; and
a sense amplifier for sensing the voltage on the sensing node.

Preferably, the memory transistors are arranged in the form of matrix, with the rows of the matrix being designated by respective word lines and the columns by respective bit lines.

Preferably, each read unit further comprises a discharge unit for discharging the first portion of the corresponding bit line in response to a control signal. The discharge unit may consist of an NMOS transistor connected between the bit line and ground potential.

Preferably, the memory device further comprises a data line precharge unit for precharging the sensing node in response to the said precharge signal. The data line precharge unit may consist of a PMOS transistor connected between the sensing node and power supply voltage.

Preferably, the means for discharging the precharge on the second portion of the bit line consists of a bias-setting NMOS transistor connected between the two portions of the bit line and receiving a reference voltage on its control terminal.

The precharge unit may consist of a PMOS transistors connected between the bit line and power supply voltage.

The present invention also provides a method of reading data from a nonvolatile semiconductor memory cell array having a plurality of NAND cell strings, each including a plurality of memory transistors and a bit line for each NAND cell string, the method comprising:
connecting a selected NAND cell string to a first portion of its corresponding bit line;
precharging a second portion of the bit line to a first voltage level;
allowing the precharge on the second portion of the bit line to discharge to the first portion of the bit line if the voltage level on the first portion of the bit line is below a given level;
connecting the second portion of the bit line to a common sensing node; and
sensing the voltage on the sensing node.

### Brief Description of the Drawings

The present invention will now be described by way of example with reference to the accompanying drawings, in which:
Fig. 1 is a block diagram of a conventional data read circuit and memory cell array of a semiconductor memory;
Fig. 2 is a timing diagram showing a read operation performed by the circuit of Fig. 1;
Fig. 3 is a block diagram of a data read circuit of a semiconductor memory according to the present invention; and
Fig. 4 is a timing diagram of a read operation performed by the circuit of Fig. 3.

### Detailed Description of the Preferred Embodiment

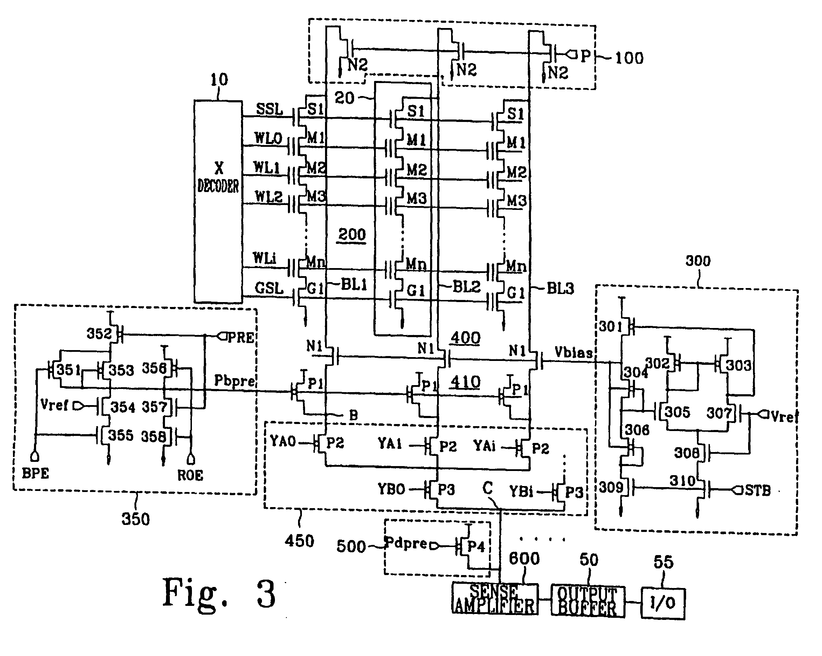

Fig. 3 is a block diagram showing a data read circuit of a NAND flash semiconductor memory. In this figure, only a sub-block including three bit lines is shown. The memory cell array 200, row decoder 10, output buffer 50 and input/output portion 55 are the same as those of Fig. 1, and an explanation of these will therefore be omitted.

Referring to Fig. 3, a bit line discharging portion 100 for discharging the bit line includes transistors N2 respectively connected to one side of the bit lines. A bit line bias setting portion 400 for setting the bias level of the bit line in response to a first reference voltage includes transistors N1 respectively connected to the other side of the bit lines. Here, the first reference voltage is supplied from a first reference voltage generator 300 consisting of transistors 301 to 310.

A bit line precharging portion 410 for precharging the bit line in response to a second reference voltage is connected to the bias setting portion 400. The second reference voltage is supplied from a second reference voltage generator 350 consisting of transistors 351 to 358. A column passing portion 450 is connected to the output of the bit line precharging portion, and consists of a plurality of PMOS transistors which pass the voltage of the bit line, according to the threshold voltage of the memory cell selected, to a sensing node C in response to a column decoding signal.

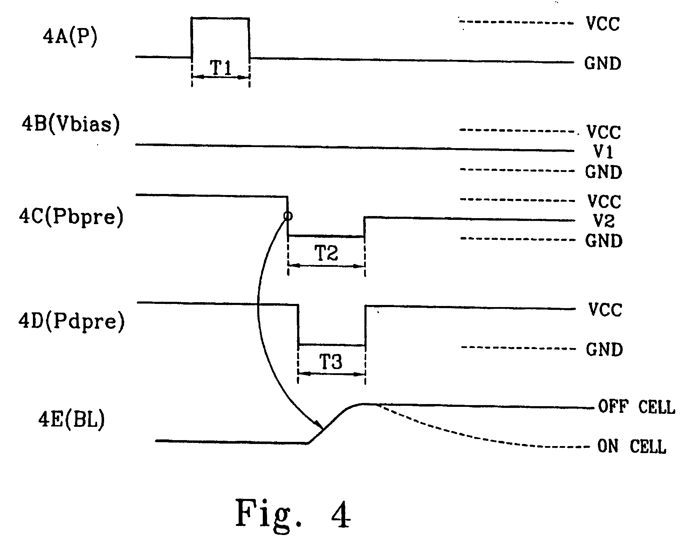

A data line precharging portion 500 receives a signal shown in Fig. 4D to precharge sensing node C. A sense amplifier 600 reads data of the memory cell selected without employing a latch by sensing the voltage on the sensing node C, and supplies it to output buffer 50. Fig. 4 shows various control signals and voltage waveforms which are applied to the portions in the data read circuit.

The data read operation according to the present invention without employing the page buffer shown in Fig. 1 will now be explained with reference to Figs. 3 and 4. Referring to Fig. 3, if a word line and bit line are selected, transistors N2 of bit line discharging portion 100 discharge the bit line selected to the ground level within a section Tl by receiving a signal P shown in Fig. 4A at the initial stage. Thereafter, transistors N1 of bit line bias setting portion 400 set the bias level of the bit line by receiving a signal V_{bias} shown in Fig. 4B as the first reference voltage.

Transistors P1 of bit line precharging portion 410 precharge the bit line by receiving a signal P_{bpre} shown in Fig. 4C as the second reference voltage. Here, signal P_{bpre} is the output signal of the current mirror. Accordingly, a voltage according to the programmed state of the memory cell selected is developed on the bit line. This voltage appears on sensing node C after passing through column passing portion 450. Here, column passing portion consists of PMOS transistors, and forms only one path according to the decoding signal applied.

Data line precharging portion 500 receives a waveform shown in Fig. 4D to precharge sensing node C during the read operation. Data line precharging portion 500 shortens the sensing time by charging the level of sensing node C during section T3. Transistor P1 of bit line precharging portion 410 is completely conducted in response to a "low" signal during section T2 shown in Fig. 4C. Transistor P1 is turned off and serves as a load transistor when the charging section is over.

Accordingly, sense amplifier 600 reads the data of the memory cell selected without employing a latch by sensing the voltage on sensing node C, and supplies it to output buffer 50. Fig. 4E shows how the potential of the bit line selected appears according to cell state.

According to the present invention, data can be read without employing a conventional page buffer, resulting in a sharp reduction of memory chip size.

## Claims

1. A nonvolatile semiconductor memory device comprising:
a memory cell array having a plurality of NAND cell strings, each including a plurality of memory transistors;
a plurality of bit lines, one for each NAND cell string;
a read unit for each bit line comprising:
a switch unit for connecting the NAND cell string to a first portion of the bit line in response to a selection signal;
a precharge unit for precharging a second portion of the bit line in response to a precharge signal;
means for discharging the precharge on the second portion of the bit line to the first portion of the bit line if the voltage level on the first portion of the bit line is below a given level; and
a column selecting unit for connecting the second portion of the bit line to a common sensing node in response to a respective column decoding signal; and
a sense amplifier for sensing the voltage on the sensing node.

2. A memory device according to claim 1 in which the memory transistors are arranged in the form of matrix, with the rows of the matrix being designated by respective word lines and the columns by respective bit lines.

3. A memory device according to claim 1 or claim 2 in which each read unit further comprises a discharge unit for discharging the first portion of the corresponding bit line in response to a control signal.

4. A memory device according to claim 3 in which the discharge unit consists of an NMOS transistor connected between the bit line and ground potential.

5. A memory device according to any preceding claim further comprising a data line precharge unit for precharging the sensing node in response to the said precharge signal.

6. A memory device according to claim 5 in which the data line precharge unit consists of a PMOS transistor connected between the sensing node and power supply voltage.

7. A memory device according to any preceding claim in which the means for discharging the precharge on the second portion of the bit line consists of a bias-setting NMOS transistor connected between the two portions of the bit line and receiving a reference voltage on its control terminal.

8. A memory device according to any preceding claim in which the precharge unit consists of a PMOS transistors connected between the bit line and power supply voltage.

9. A method of reading data from a nonvolatile semiconductor memory cell array having a plurality of NAND cell strings, each including a plurality of memory transistors and a bit line for each NAND cell string, the method comprising:
connecting a selected NAND cell string to a first portion of its corresponding bit line;
precharging a second portion of the bit line to a first voltage level;
allowing the precharge on the second portion of the bit line to discharge to the first portion of the bit line if the voltage level on the first portion of the bit line is below a given level;
connecting the second portion of the bit line to a common sensing node; and
sensing the voltage on the sensing node.

## Patentansprüche

1. Nichtflüchtiges Halbleiterspeicherbauelement, das Folgendes umfasst:
eine Speicherzellenanordnung mit einer Mehrzahl von NAND-Zellenketten, die jeweils eine Mehrzahl von Speichertransistoren beinhalten;
eine Mehrzahl von Bitleitungen, eine für jede NAND-Zellenkette;
eine Abtasteinheit für jede Bitleitung, die Folgendes umfasst:
eine Schalteinheit zum Verbinden der NAND-Zellenkette mit einem ersten Abschnitt der Bitleitung als Reaktion auf ein Selektionssignal;
eine Vorladeeinheit zum Vorladen eines zweiten Abschnitts der Bitleitung als Reaktion auf ein Vorladesignal;
Mittel zum Entladen der Vorladung auf dem zweiten Abschnitt der Bitleitung auf den ersten Abschnitt der Bitleitung, wenn der Spannungspegel auf dem ersten Abschnitt der Bitleitung unter einem bestimmten Wert liegt; und
eine Spaltenauswahleinheit zum Verbinden des zweiten Abschnitts der Bitleitung mit einem gemeinsamen Abtastknoten als Reaktion auf ein jeweiliges Spaltendecodiersignal; und
einen Abtastverstärker zum Abtasten der Spannung auf dem Abtastknoten.

2. Speicherbauelement nach Anspruch 1, bei dem die Speichertransistoren in der Form einer Matrix angeordnet sind, wobei die Reihen der Matrix durch jeweilige Wortleitungen und die Spalten durch jeweilige Bitleitungen designiert werden.

3. Speicherbauelement nach Anspruch 1 oder Anspruch 2, bei dem jede Abtasteinheit ferner eine Entladeeinheit zum Entladen des ersten Abschnitts der entsprechenden Bitleitung als Reaktion auf ein Steuersignal umfasst.

4. Speicherbauelement nach Anspruch 3, bei dem die Entladeeinheit aus einem NMOS-Transistor besteht, der zwischen der Bitleitung und Massepotential geschaltet ist.

5. Speicherbauelement nach einem der vorherigen Ansprüche, ferner umfassend eine Datenleitungsvorladeeinheit zum Vorladen des Abtastknotens als Reaktion auf das genannte Vorladesignal.

6. Speicherbauelement nach Anspruch 5, bei dem die Datenleitungsvorladeeinheit aus einem PMOS-Transistor besteht, der zwischen dem Abtastknoten und der Stromversorgungsspannung geschaltet ist.

7. Speicherbauelement nach einem der vorherigen Ansprüche, bei dem das Mittel zum Entladen der Vorladung auf dem zweiten Abschnitt der Bitleitung aus einem Vorspannungseinstell-NMOS-Transistor besteht, der zwischen zwei Abschnitten der Bitleitung geschaltet ist und eine Referenzspannung auf seinem Steueranschluss empfängt.

8. Speicherbauelement nach einem der vorherigen Ansprüche, bei dem die Vorladeeinheit aus einem PMOS-Transistor besteht, der zwischen der Bitleitung und der Stromversorgungsspannung geschaltet ist.

9. Verfahren zum Lesen von Daten von einer nichtflüchtigen Halbleiterspeicherzellenanordnung mit einer Mehrzahl von NAND-Zellenketten, die jeweils eine Mehrzahl von Speichertransistoren und eine Bitleitung für jede NAND-Zellenkette beinhalten, wobei das Verfahren die folgenden Schritte umfasst:
Verbinden einer gewählten NAND-Zellenkette mit einem ersten Abschnitt ihrer entsprechenden Bitleitung;
Vorladen eines zweiten Abschnitts der Bitleitung auf einen ersten Spannungspegel;
Entladenlassen der Vorladung auf dem zweiten Abschnitt der Bitleitung auf den ersten Abschnitt der Bitleitung, wenn der Spannungspegel auf dem ersten Abschnitt der Bitleitung unter einem bestimmten Wert liegt; und
Verbinden des zweiten Abschnitts der Bitleitung mit einem gemeinsamen Abtastknoten; und
Abtasten der Spannung auf dem Abtastknoten.

## Revendications

1. Dispositif à mémoire rémanente à semi-conducteurs comprenant ;
un réseau de cellules de mémoire ayant une pluralité de chaînes de cellules NAND, comprenant chacune une pluralité de transistors de mémorisation ;
une pluralité de lignes de bits, une pour chaque chaîne de cellules NAND;
une unité de lecture pour chaque ligne de bits comprenant :
une unité de commutation pour connecter la chaîne de cellules NAND à une première portion de la ligne de bits en réponse à un signal de sélection ;
une unité de pré-charge pour pré-charger une deuxième portion de la ligne de bits en réponse à un signal de pré-charge ;
un moyen pour décharger la pré-charge sur la deuxième portion de la ligne de bits dans la première portion de la ligne de bits si le niveau de tension sur la première portion de la ligne de bits est situé en dessous d'un niveau donné ; et
une unité de sélection de colonne pour connecter la deuxième portion de la ligne de bits à un noeud de détection commun en réponse à un signal de décodage de colonne respectif ; et un amplificateur de détection pour détecter la tension sur le noeud de détection.

2. Dispositif à mémoire selon la revendication 1 dans lequel des transistors de mémorisation sont disposés sous la forme d'une matrice, les rangées de cette matrice étant désignées par les lignes de mots respectives et les colonnes par les lignes de bits respectives.

3. Dispositif à mémoire selon la revendication 1 ou 2 dans lequel chaque unité de lecture comprend également une unité de décharge pour décharger la première portion de la ligne de bits correspondante en réponse à un signal de commande.

4. Dispositif à mémoire selon la revendication 3 dans lequel l'unité de décharge consiste en un transistor MOS à canal N connecté entre la ligne de bits et le potentiel de la masse.

5. Dispositif à mémoire selon l'une quelconque des revendications précédentes comprenant également une unité de pré-charge de ligne de données pour pré-charger le noeud de détection en réponse audit signal de pré-charge.

6. Dispositif à mémoire selon la revendication 5 dans lequel l'unité de pré-charge de la ligne de données consiste en un transistor MOS à canal P connecté entre le noeud de détection et la tension d'alimentation.

7. Dispositif à mémoire selon l'une quelconque des revendications précédentes dans lequel le moyen pour décharger la pré-charge sur la deuxième portion de la ligne de bits consiste en un transistor MOS à canal N définissant la polarisation connecté entre les deux portions de la ligne de bits et recevant une tension de référence sur sa borne de commande.

8. Dispositif à mémoire selon l'une quelconque des revendications précédentes dans lequel l'unité de pré-charge consiste en un transistor MOS à canal P connecté entre la ligne de bits et la tension d'alimentation.

9. Méthode de lecture des données à partir d'un réseau de cellules de mémoire rémanente à semi-conducteurs ayant une pluralité de chaînes de cellules NAND, comprenant chacune une pluralité de transistors de mémorisation et une ligne de bits pour chaque chaîne de cellules NAND, cette méthode comprenant :
la connexion d'une chaîne de cellules NAND à une première portion de sa ligne de bits correspondante ;
la pré-charge d'une deuxième portion de la ligne de bits à un premier niveau de tension ;
la possibilité donnée à la pré-charge sur la deuxième portion de la ligne de bits de se décharger dans la première portion de la ligne de bits si le niveau de tension sur la première portion de la ligne de bits est en dessous d'un niveau donné ;
la connexion de la deuxième portion de la ligne de bits à un noeud de détection commun ; et
la détection de la tension sur le noeud de détection.
